# EUROPÄISCHE PATENTANMELDUNG

(11) **EP 2 056 165 A1**
(43) Veröffentlichungstag der Anmeldung: **06.05.2009**
(21) Anmeldenummer: 08017472.5
(22) Anmeldetag: 06.10.2008
(51) Int. Cl.: G03F 7/20

(54) **Fotoplott-Verfahren und Anordnung zur Aufzeichnung eines computergespeicherten Rasterbildes auf einen ebenen lichtempfindlichen Aufzeichnungsträger**

(30) Priorität: 31.10.2007 DE 102007051990
(71) Anmelder: MIVA Technologies GmbH, 71101 Schönaich (DE)
(72) Erfinder: Pagan, Robin, 70563 Stuttgart (DE)
(74) Vertreter: Blutke, Klaus Wilhelm

(57) **Zusammenfassung**

Das aufzuzeichnende Rasterbild T (Gesamtbild) wird computerprogrammgesteuert bildpunktweise als Folge von Teilbildern (R1, R2, R3, R4,...) aufgezeichnet auf einen sich in Richtung v durch eine Belichtungsstation hindurchbewegenden Aufzeichnungsträger (1).

Alle Bildpunkte eines Teilbildes werden gleichzeitig aufgezeichnet.

Die Teilbilder werden zu Blitzzeitpunkten (t1, t2, t3, t4 ...) aufgezeichnet, zu denen sich der Aufzeichnungsträger (1) um jeweils eine äquidistante Strecke (d) weiterbewegt hat. Aufeinanderfolgende Teilbilder überlagern sich teilweise derart, daß die überlagerten Teilbilder immer mit einem Abschnitt des aufzuzeichnenden Gesamtbildes deckungsgleich sind.

Die Aufzeichnung erfolgt mittels einer Licht-Steuer-Einheit , vorzugsweise einem Kippspiegel-Elemente-Halbleiter-Chip, mit matrixartig angeordneten Licht-Steuer-Elementen. Die Lichtsteuer-Einheit wird für die Aufzeichnung jedes Teilbildes computerprogrammgesteuert mit einem entsprechenden Steuermuster geladen. Bei Blitzbelichtung der Licht-Steuer-Einheit leitet - wenn das Steuermuster es so vorsieht- jedes Licht-Steuer-Blement einen Lichtstrahl auf die ihm zugeordnete Bildpunkt-Rasterposition des Aufzeichnungsträgers zur Erzeugung eines Bildpunktes.

Die Erfindung dient insbesondere der Erstellung fotographischer Vorlagen für gedruckte Leiterplatten, der Direkthelichtung von Leiterplattenmaterial u.ä. und der Erstellung dreidimensionaler Strukturen für optische Elemente.

## Beschreibung

Die Erfindung bezieht sich auf ein Fotoplott-Verfahren und eine Anordnung zur Aufzeichnung eines computergespeicherten Rasterbildes auf einen ebenen lichtempfindlichen Aufzeichnungsträger.
Fotoplottverfahren und -Anordnungen dienen z.B. der Herstellung fotographischer Vorlagen für gedruckte Leiterplatten. Nach dem Stand der Technik sind eine Vielzahl unterschiedlicher Verfahren und Anordnungen bekannt:
Im US Patent 5434600 ist ein Aufzeichnungssystem beschrieben, bei dem ein Aufzeichnungsträger auf einer rotierenden Trommel angeordnet ist, auf dem nacheinander Zeilenabschnitte mit Bildelementen aufgezeichnet werden.
In dem US Patent 4739416 und US Patent 4357619 sind Aufzeichnungssysteme beschrieben , bei dem der Aufzeichnungsträger ebenfalls auf einer rotierenden Trommel angeordnet ist. Die Aufzeichnung erfolgt zeilenweise und erfordert eine Lochmaske und eine Vielzahl von Lichtquellen.
In der DE 41 21 809 A1 ist ein Belichtungs- und Modulationssystem beschrieben, welches einen zweidimensionalen Lichtmodulator mit eine Mehrzahl von Reihen lichtmodulierender Zellen aufweist, sowie eine Einrichtung zum Abbilden des Lichtmodulators auf einen lichtempfindlichen Aufzeichnungsträger. Der Lichtmodulator und der Aufzeichnungsträger werden derart gegeneinander verschoben wie die Verschiebung bzw. Neuaufnahme von Information in den Reihen des Lichtmodulators erfolgt.

In der Patentschrift DE 197 16 240 ist ein Verfahren zur Aufzeichnung eines computergespeicherten Rasterbildes auf einem lichtempfindlichen Aufzeichnungsträger beschrieben.Das aus Rasterpunkten bestehende Rasterbild wird mittels einer eine Vielzahl von Löchern aufweisenden Lochmaske aufgezeichnet. Jedes Loch läßt einen gesteuerten Lichtstrahl durch zur Aufzeichnung eines einem Rasterpunkt entsprechenden Bildelementes auf dem Aufzeichnungsträger.
Der Aufzeichnungsträger ist in gedachte matrixartig angeordnete Aufzeichnungsträger-Rasterbild-Teilflächen aufgeteilt, von denen jede mehrere matrixartig angeordnete Bildelemente-Positionen aufweist. Die Lochmaske und eine Anordnung steuerbarer Lichtstrahl-Elemente wird gegenüber dem Aufzeichnungsträger verschoben zur Aufzeichnung der Bildelemente in den verschiedenen Bildelement-Positionen. Mindestens ein Teil der Bildelemente in den gleichen Bildelement-Positionen der Aufzeichnungsträger-Rasterbild-Teilflächen wird gleichzeitig aufgezeichnet, wobei die Bildelemente einer Aufzeichnungsträger-Rasterbild-Teilfläche nacheinander aufgezeichnet werden.
Die Anordnung steuerbarer Lichtstrahl-Elemente kann von einer LCD- Matrix oder einem Kippspiegel-Halbleiterchip gebildet werden.
Die Beaufschlagung einer LCD-Matrix kann z.B. mit Dauerlicht oder einem kurzzeitigen Xenon- oder Laser-Blitz erfolgen. Die Beaufschlagung eines Kippspiegel-Halbleiterchip erfolgt im Blitzbetrieb.

Alle bisherigen mit Blitzbelichtungen ( grundsätzlich mit einer Lichtquelle) arbeitenden Verfahren und Anordnungen weisen den Nachteil auf, daß sich für die über die gesamte Aufzeichnungsfläche verteilten Bildpunkte keine Homogenität der Aufzeichnungsstärke ergibt, da die auf eine Bildrasterpunktposition des Aufzeichnungsträgers einwirkende Lichtenergie je nach Lage dieses Punktes in der Belichtungsfläche unterschiedlich ist.

Es ist deshalb Aufgabe der Erfindung, ein Aufzeichnugsverfahren bzw. eine Anordnung anzugeben, welches/welche die Homogenität der Aufzeichnung verbessert bei Verwendung von Blitzlicht, dessen Energie bei einer nur einmaligen Belichtung zur Aufzeichnung eines Bildpunktes nicht ausreichend wäre.

Diese Aufgabe der Erfindung wird durch die im kennzeichnenden Teil der Ansprüche 1 bzw. 18 angebenen Merkmale gelöst.

Vorteilhafte Weiterbildungen der Erfindung sind in den Unteransprüchen gekennzeichnet.

Ein Ausführungsbeispiel und Darstellungen zur Wirkungsweise der Erfindung sind in den Zeichnungen dargestellt und werden im folgenden näher beschrieben. Es zeigen:
FIG.1 eine schematische Darstellung einer erfindungsgemäßen Anordnung zur Aufzeichnung eines computergespeicherten Rasterbildes auf einem ebenen lichtempfindlichen Aufzeichnungsträger,
FIG.2A eine schematische "schrittweise" Darstellung der Bildaufzeichnung an Hand eines Beispiels für ein aufzuzeichnendes Gesamtbild;
FIG. 2B eine schematische Darstellung von vier sich einander teilweise überlagernden Teilbildern R1, R2, R3 und R4 zur Ausbildung eines Abschnittes des Gesamtbildes;
FIG.3 eine schematische Darstellung eines Aufzeichnungsträgers mit streifenweiser Bildaufzeichnung;
FIG.4 eine Darstellung der Funktion der Aufzeichnungsstärke z für Bildpunkte in Abhängigkeit von ihrer Position entlang der Breite eines Teilbildes;
FIG.5 eine schematische Darstellung zweier sich teilweise überlagernder Streifen für die Bildaufzeichnung mit einem jeweils gauß-kurven-ähnlichen Verlauf der Aufzeichnungsstärke der Bildpunkte in Abhängigkeit von ihrer Position entlang der Streifenbreite.

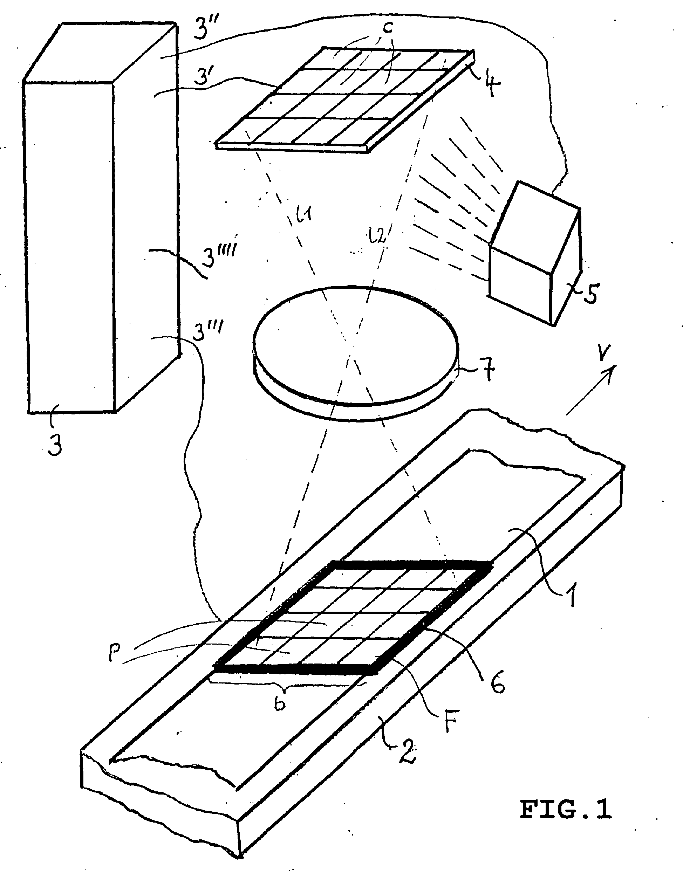

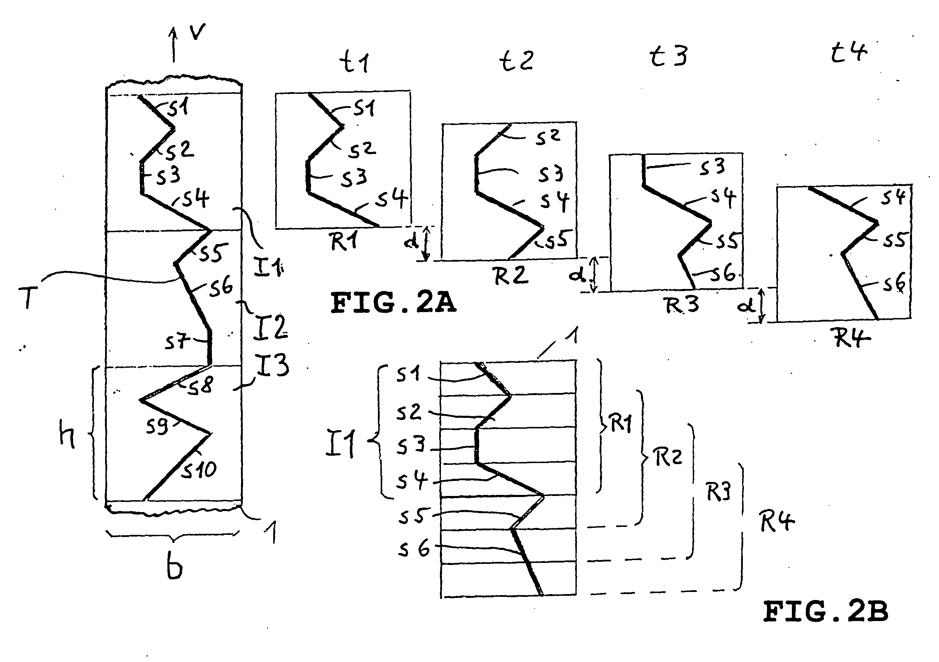

FIG.1 zeigt eine schematische Darstellung einer erfindungsgemäßen Anordnung zur Aufzeichnung eines computergespeicherten Rasterbildes auf einem ebenen lichtempfindlichen Aufzeichnungsträger 1.
Das auf den ebenen lichtempfindlichen Aufzeichnungsträger 1 aufzuzeichnende Rasterbild T (s.FIG.2) ist in einem Computer 3 gespeichert. Die Aufzeichnung des Rasterbildes erfolgt computerprogrammgesteuert.
Der Computer 3 ist über eine Steuerleitung 3' mit einer Licht-Steuer-Einheit 4 verbunden.
Die Licht-Steuer-Einheit 4 wird zu bestimmten Zeitpunkten mit Blitzlicht beaufschlagt. Das Blitzlicht wird in einer Blitzlicht-Einheit 5 erzeugt.
Der Computer 3 ist über eine Steuerleitung 3'' mit der Blitzlicht-Einheit 5 verbunden.
Die Licht-Steuer-Einheit 4 besteht aus einer Vielzahl matrixartig angeordneter Licht-Steuer-Elemente c .
Die Bildaufzeichnung erfolgt in einem Belichtungsflächenfeld F einer Belichtungsstation 6 .

Die Belichtungsstation 6 nimmt zu allen Belichtungszeitpunkten immer die gleiche Position gegenüber der Licht-Steuer-Einheit 4 ein; das Belichtungsflächenfeld F ist in gedachte matrixartig angeordnete Bildpunkt-Rasterpositionen p aufgeteilt.
Die Bildpunkt-Rasterpositionen p des Belichtungsflächenfeldes F und die matrixartig angeordneten Licht-Steuer-Elemente c der Licht-Steuer-Einheit 4 entsprechen einander.
Jedes Licht-Steuer-Element ist einer Bildpunkt-Raster-Position des Belichtungsflächenfeldes F zugeordnet.
Der Aufzeichnungsträger (1) ist auf einer Verschiebeeinrichtung 2 (z.B. einem Transportschlitten) angeordnet, welcher in geradliniger Richtung v unter der Licht-Steuer-Einheit 4 mit kontinuierlicher Geschwindigkeit bewegt wird.
Die Ebene, in welcher der Aufzeichnungsträger 1 liegt, und die Ebene , in welcher die Licht-Steuer-Einheit 4 liegt, haben immer den gleichen Abstand.
Für jeden Blitzzeitpunkt erhält die Licht-Steuer-Einheit 4 vom Computer ein Steuermuster für die Bildaufzeichnung im Belichtungsflächenfeld F der Belichtungsstation 6 programmgesteuert "mitgeteilt".
Durch dieses Steuermuster werden die Licht-Steuer-Elemente derart gesteuert, daß bei ihrer Beaufschlagung mit Blitzlicht jedes Licht-Steuerelement einen Lichtstrahl auf die ihm zugeordnete Bildpunkt-Raster-Position des Belichtungsflächenfeldes F richtet oder nicht. Ein auf eine Bildpunkt-Raster-Position auftreffender Lichtstrahl bewirkt die Aufzeichnung eines Bildpunktes ; ein nicht auftreffender Lichtstrahl bewirkt keine Bildpunktaufzeichnung.
Die Aufzeichnung eines Bildes im Belichtungsflächenfeldes F erfolgt gleichzeitig für alle Bildpunktpositionen.
Zwischen dem Aufzeichnungsträger 1 und der Licht-Steuer-Einheit 4 ist ein den Abbildungwsmaßstab bestimmendes Objektiv 7 angeordnet. Die Aufzeichnung der Bildpunkte - bezogen auf die ihnen entsprechenden Licht-Steuer-Elemente- erfolgt seiten- und höhenverkehrt, wie beispielsweise durch die Lichtstrahlen 11 und 12 angedeutet.

Der Computer 3 ist über eine Steuerleitung 3''' mit der Verschiebe-Einrichtung 2 zur Erfassung der aktuellen Verschiebeposition verbunden.

Über die Leitung 3'''' erhält der Computer 3 die Daten für das aufzuzeichnende Rasterbild mitgeteilt.

FIG. 2A zeigt eine schematische "schrittweise" Darstellung der erfindungsgemäßen Bildaufzeichnung an Hand eines Beispiels für ein aufzuzeichnendes Gesamtbild T.

FIG. 2B zeigt eine schematische Darstellung von vier sich einander teilweise überlagernden Teilbildern R1, R2, R3 und R4 zur Ausbildung eines Abschnittes des Gesamtbildes im Bildfeld I1.

Zum besseren Verständnis der Aufzeichnung , z.B. des ersten Teilbildes R1 in der Belichtungsstation gemäß einem entsprechenden Steuermuster in der Licht-Steuer-Einheit (4) sei folgendes bemerkt:
Das Steuermuster steuert die Aufzeichnung der Bildelemente in allen matrixartig angeordneten Bildelemente-Positionen der Belichtungsfläche. Diese Bildelemente entsprechen den Rasterpunkten des Computer-Rasterbildes für das Teilbild R1. Für einen Rasterpunkt im "an-Status" wird ein Bildelement erzeugt; für einen Rasterpunkt im "aus-Status" wird kein -also ein fehlendes- Bildelemnt erzeugt.
Für einen Rasterpunkt im "an-Status" bewirkt ein entsprechender Steuerbefehl an das diesem Rasterpunkt zugeordnete Licht-Steuer-Element, daß dieses bei Belichtung einen Lichtstrahl auf den Aufzeichnungsträger zur Erzeugung eines Bildpunktes richtet und zwar an einer dem Licht-Steuer-Element zugeordneten Position.

Für einen Rasterpunkt im "aus-Status" bewirkt ein entsprechender Steuerbefehl an das diesem Rasterpunkt zugeordnete Licht-Steuer-Element, daß dieses bei Belichtung keinen Lichtstrahl auf den Aufzeichnungsträger zur Erzeugung eines Bildpunktes richtet.
Das Steuermuster für die Licht-Steuer-Einheit umfaßt die Steuerbefehle für alle Licht-Steuer-Elemente, aufgrund derer das Teilbild R1 gleichzeitig erzeugt wird.

Das aufzuzeichnende Gesamt-Bild T erstreckt sich über drei gedacht auf dem Aufzeichnungsträger 1 untereinander angeordnete Bildfelder I1, I2, I3.

Dieses Gesamtbild T besteht (beispielsweise) aus den Spursegmenten s1, s2, s3, s4, s5, s6, s7, s8, s9 , s10.
Der auf der in FIG.1 gezeigten Verschiebe-Einrichtung 2 angeordnete Aufzeichnungsträger 1 wird - wie bereits erwähntkontinuierlich in Richtung v unter der Licht-Steuer-Einheit 4 vorbeibewegt.
Zum Blitz-Zeitpunkt t1 ist die Licht-Steuer-Einheit 1 mit einem entsprechenden Steuermuster zur Aufzeichnung des ersten Teilbildes R1 geladen. Die Aufzeichnung dieses Teilbildes R1 erfolgt während der kurzzeitigen Blitzbelichtung zum Zeitpunkt t1 auf dem Aufzeichnungsträger in der Belichtungsstation 6 (FIG.1) im Bereich der Belichtungsfläche F.
(Die Belichtungsfläche F hat die Größe einer Teilbildfläche bzw. eines Bildfeldes).
Die Blitzdauer ist so kurz, daß bei der Bildaufzeichnung auftretende Bewegungsunschärfen vernachlässigbar sind.
Das zum Blitzzeitpunkt t1 aufgezeichnete Teilbild R1 besteht aus den Spursegmenten s1, s2, s3 und s4 .
Aus Übersichtsgründen ist das erste Teilbild R1 separat neben dem Aufzeichnungsträger 1 (mit dem gedachten aufzuzeichnenden Gesamtbild T) dargestellt; die entsprechenden Spursegmente s1, s2, s3 und s4 des Teilbildes R1 erscheinen bezüglich der Spursegmente s1, s2, s3 und s4 gedachten Gesamtbildes T nur seitenverschoben versetzt, nicht aber höhenverschoben.

Zu weiteren Blitzzeitpunkten werden weitere Teilbilder aufgezeichnet, die sich auf dem Aufzeichnungsträger teilweise überlagern. Eine Blitzbelichtung wird ausgelöst, wenn sich der Aufzeichnungsträger 1 um jeweils eine äquidistante Strecke d gegenüber der Licht-Steuer-Einheit 4 verschoben hat.

Für den Blitz-Zeitpunkt t2 ( die Verschiebe-Einrichtung mit dem Aufzeichnugsträger hat sich zu diesem Zeitpunkt t2 gegenüber dem Zeitpunkt t1 in Richtung v um die Distanz d weiterbewegt) wird die Licht-Steuer-Einheit mit einem Steuermuster zur Aufzeichnung des zweiten Teilbildes R2 geladen. Dieses zweite Teilbild R2 wird wie auch das erste Teilbild R1 in der Belichtungsstation 6 auf demm Aufzeichnungsträger 1 aufgezeichnet. Das zweite Teilbild besteht aus den Spursegmenten s2, s3, s4 und s5 ; es ist aus Übersichtsgründen separat seitlich versetzt neben dem Aufzeichnungsträger 1 mit dem gedachten Gesamtbild T und neben dem ersten Teilbild R1 dargestellt; die gleichen Spursegmente z.B. s3 im Gesamtbild T und im Teilbild R1 und R2 haben die gleiche Höhenlage.

Zum Zeitpunkt t1 erfolgt die Aufzeichnung des ersten Teilbildes R1, zum Zeitpunkt t2 die des zweiten Teilbildes R2.
Beide Teilbilder R1 und R2 erscheinen auf dem Aufzeichnungsträger 1 um die Strecke d verschoben; die Teilbilder überlagern sich derart (FIG.2B), daß z.B. das Segment s3 des ersten Teilbildes R1 deckungsgleich mit dem Segemnt s3 des zweiten Teilbildes R2 auf dem Aufzeichnungsträger 1 aufgezeichnet wird.

Die Verschiebestrecke d ist kleiner als die Kantenlänge h eines Bildfeldes (bzw. eines Teilbildes). In diesem Beispiel beträgt sie aus Übersichtsgründen nur ¼ der Kantenlänge h.
In realisierten Einrichtungen beträgt d z.B. 1 mm bei einer Kantenlänge h des Teilbildes von 10 mm; h muß nicht ein ganzzahliges Vielfaches von d sein.

Für den Blitz-Zeitpunkt t3 ( die Verschiebeeinrichtung mit dem Aufzeichnugsträger hat sich zum Zeitpunkt t3 seit dem Zeitpunkt t2 in Richtung v wiederum die äquidistante Strecke d weiterbewegt), wird die Licht-Steuer-Einheit 4 mit einem Steuermuster zur Aufzeichnung des dritten Teilbildes R3 in der Belichtungsstation geladen; das dritte Teilbild R3 besteht aus den Spursegmenten s3, s4 , s5 und einem Teil von s6.

Analog zum Vorhergesagten ist das dritte Teilbild R3 wie auch das nachfolgend erwähnte vierte Teilbild R4 in FIG. 2A seitlich versetzt zum gedachten Gesamtbild T und zu den Teilbildern R1 und R2 dargestellt.

Wie aus FIG. 2B ersichtlich, überlagern sich die Teilbilder R1, R2 und R3 auf dem Aufzeichnungsträger 1 derart, daß z.B. das Spursegment s3 von R1, R2 und R3 deckungsgleich auf derselben Stelle des Aufzeichnungsträgers erscheint.

Für den Blitz-Zeitpunkt t4 ( die Verschiebeeinrichtung mit dem Aufzeichnugsträger hat sich zum Zeitpunkt t4 seit dem Zeitpunkt t3 in Richtung v um die äquidistante Strecke d weiterbewegt), wird die Licht-Steuer-Einheit 4 mit einem Steuermuster zur Aufzeichnung eines vierten Teilbildes R4 in der Belichtungsstation 6 geladen.
Das vierte Teilbild R4 besteht aus den Spursegmenten s4 , s5 und s6. Das Teilbild R4 ist in FIG. 2A ebenfalls entsprechend seitenversetzt dargestellt.

Durch Überlagerung der vier Teilbilder R1, R2, R3 und R4 ( siehe FIG. 2B) hat z.B. das Segment s4 im gedachten Gesamtbild T (FIG.2A) nacheinander (während der Blitzzeitpunkte t1, t2, t3 und t4) eine vierfache Belichtung erfahren; dies ermöglicht eine Bildaufzeichnung mit relativ "schwacher" Blitzlichtenergie.

Eine sehr hohe erforderliche Blitzlichtenergie zur Bildaufzeichnung durch eine einzige Blitzbelichtung (nach dem Stand der Technik stehen solche Blitzlicht-Einheiten noch nicht zur Verfügung) kann durch die erfindungsgemäße "Mehrfachbelichtung" ersetzt werden.

Das für jeden Blitzzeitpunkt aufzuzeichnende Teilbild erhält die Licht-Steuer-Einheit als Steuermuster computerprogrammgesteuert mitgeteilt ( unter Berücksichtigung der zwischen zwei aufeianderfolgenden Blitzzeitpunkten erfolgten Verschiebung des Aufzeichnungsträgers in Richtung v).

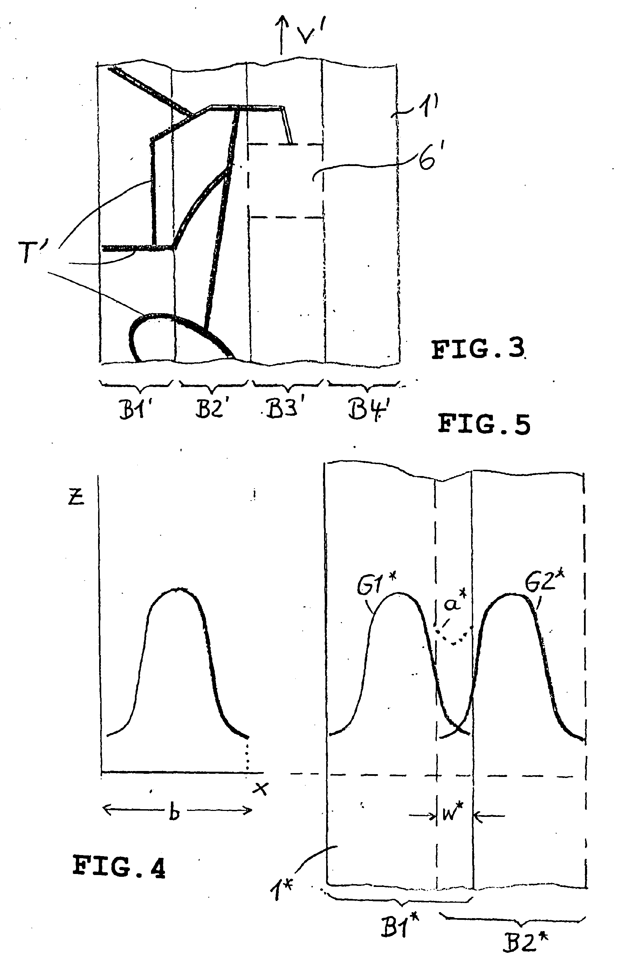

FIG. 3 zeigt eine schematische Darstellung eines Aufzeichnungsträgers 1' mit streifenweiser Bildaufzeichnung.
Das aufzuzeichnende Bild T' erstreckt sich über mehrere nebeneinanderliegende Bildflächenstreifen B1', B2', B3', B4'. Die Bildaufzeichnung erfolgt streifenweise. Die Belichtungsfläche in der Belichtungsstation hat die Breite b eines Streifens. Der Aufzeichnungsträger wird gegenüber der Licht-Steuer-Einheit ( nicht dargestellt) in Richtung v' bewegt. Bei der Bild-Aufzeichnung in einem Streifen werden erfindungsgemäß die Teilbilder teilweise überlagert.
Nach der Bildaufzeichnung in einem Streifen wird die Verschiebeeinrichtung, auf der der Aufzeichnungsträger angeordnet ist, zurückgesetzt und seitwärts um Streifenbreite verschoben. Dann beginnt die Bildaufzeichnung im nächsten Streifen usw. FIG. 3 zeigt den aktuellen Stand einer Bildaufzeichnung T', welche schon für die Streifen B1', B2' und einen Teil des Streifens B3' erfolgt ist.

Die Aufzeichnung einander teilweise überlagernder Teilbilder bedingt eine Verbesserung der Homogenität der Bildqualität (der Aufzeichnungsstärke) der einzelnen Bildpunkte an den Bildpunkt-Raterpositionen in Richtung der Bewegungsrichtung v bzw. v' des Aufzeichnungsträgers.

Senkrecht zu dieser Bewegungsrichtung v (v') können sich allerdings Abweichungen von einer homogenen Aufzeichnungsstärke ergeben.

FIG.4 zeigt eine Darstellung der Funktion der Aufzeichnungsstärke z für Bildpunkte in Abhängigkeit von ihrer Position quer zur Bewegungsrichtung v bzw. v' des Aufzeichnungsträgers , also entlang der Breite b eines Teilbildes. Diese Funktion kann einen Gaußkurven-ähnlichen Verlauf aufweisen; die Aufzeichnungsstärke ist in der Mitte des Teilbildes höher als an seinen seitlichen Rändern.

Zur Verringerung solcher Abweichungen werden zunächst diese Abweichungen (senkrecht zur Bewegungsrichtung v bzw. v') meßtechnisch als Funktion des Ortes erfaßt.

Unter Berücksichtigung und zur Verringerung dieser Abweichungen können die Licht-Steuer-Elemente in der Licht-Steuer-Einheit computerprogrammgesteuert derart gesteuert werden, daß in den Teilbildern Licht-Steuer-Elemente (für Bildpunkte ursprünglich zu hoher Aufzeichnungsstärke) deaktiviert werden

Alternativ kann aber auch zwischen der Licht-Steuer-Einheit (4) und dem Aufzeichnungsträger (1) ein diese Abweichungen verringerndes optisches Filter ( nicht dargestellt) angeordnet werden.

Eine weitere Möglichkeit zur Verringerung solcher Abweichungen liegt in einer streifenweisen Bildaufzeichnung mit sich randwärts überlagernden Bildstreifen.

FIG.5 zeigt
eine schematische Darstellung zweier sich randwärts überlagernder Streifen B1* und B2* für die Bildaufzeichnung , wobei jeder Streifen einen Gaußkurven-ähnlichen Verlauf G1*, G2* der Aufzeichnungsstärke der Bildpunkte gemäß FIG.4. aufweist.
Für die Bildaufzeichnung im Überlagerungs-Bereich w* ergibt sich eine Überlagerung der Aufzeichnung im Streifen B1* mit der im Streifen B2* .
Die Aufzeichnung im Streifen B1* erfolgt unter Berücksichtigung der Kurve G1*; die im Streifen B2* unter Berücksichtigung der Kurve G2*, so daß sich insgesamt gesehen für die Aufzeichnung eines Bildpunktes im Überlagerungs-Bereich w* eine Aufzeichnungsstärke ergibt, welche aus der Addition der Ordinatenwerte der Kurven G1* und G2* folgt (gepunktete Darstellung a*).

Die Erfindung ist nicht auf das zuvor beschriebene Ausführungsbeispiel beschränkt:
Die Verschiebung des Aufzeichnungsträgers gegenüber der Licht-Steuer-Einheit bzw. der Licht-Steuer-Einheit gegenüber dem Aufzeichnungsträger kann auch im Start-Stop-Betrieb erfolgen. Die Umsetzung des Steuermusters der Licht-Steuer-Einheit in steuerbare Lichtstrahlen zur Bildaufzeichnung kann auf unterschiedliche Art und Weise erfolgen:
a) über ein blitzlichtbeausfschlagtes Kippspiegel-Elemente-Halbleiter-Chip ,
b) über eine Matrix blitzlichtbeausfschlagter steuerbarer Licht-Ventil-Elemente.
c) über eine Matrix Blitzlicht emittierender Elemente .

Die Größe des Belichtungsfeldes in der Belichtungsstation (6) flächenfeldes kann durch ein zwischen der Licht-Steuer-Einheit (4) und dem Aufzeichnungsträger (1) angeordnetes maßstabsbestimmendes Objektiv (7) bestimmt werden.

Die Belichtung des Aufzeichnungsträgers mit Blitzen gleicher oder nahezu gleicher Blitzenergie bedingt erfindungsgemäß Aufzeichnungen mit durchgehender Aufzeichnungstiefe, d.h., die belichteten Stellen erfassen die ganze Schichtdicke der lichtempfindlichen Schicht und werden in dem auf die Belichtung folgenden Ätzprozeß weggeätzt.

Erfindungsgemäß ist es jedoch auch möglich, Aufzeichnungen mit unterschiedlicher Aufzeichnungstiefe zu erzeugen:

Hierfür erfolgt die Aufzeichnung eines Bildes in mehreren Durchläufen des Aufzeichnungsträgers durch die Belichtungsstation. In jedem Durchlauf erfolgt die Belichtung des Aufzeichnungsträgers mit Blitzen gleicher oder nahezu gleicher Blitzenergie, jedoch ist die Blitzenergie pro Durchlauf unterschiedlich. Die Verschiebe-Einrichtung muß pro Durchlauf von derselben Ausgangsposition in Verschieberichtung v gestartet werden.

Hierdurch können erfindungsgemäß dreidimensionalen Strukturen in der lichtempfindlichen Schicht erzeugt werden. Solche Strukturen können als optische Elemente zur optischen oder Phasen-Fokussierung verwendet werden, z.B. als Linse oder Linsen-Feld zur optischen Fokussierung von Licht,
oder zur Phasen-Fokussierung von Licht, z.B. in sogenannten Fresnel-Beugungsgittern.
Es ist bekannt, eine Lichtbündelung durch Einsatz eines auf dem Huygenschen Prinzip beruhenden Fresnel-Beugungsgitter zu bewirken ( derartige Beugungsgitter sind als sogenannte Fresnelzone-plates in der Druckschrift "OPTICS", Hecht & Zajac, 1974 by Addison-Wesley Publishing Company, beschrieben. Ein solches lichtwellenlängenspezifisches Beugungsgitter wird durch ebene konzentrische auf lichtdurchlässigem Trägermaterial aufgebrachte Ringe aus Crom oder Photoemulsionen gebildet.
Das Beugungsgitter bewirkt, daß auftreffendes Licht durch die in der Mitte dieses Gitters angeordnete ( z.B. runde) Öffnung geleitet wird.
Der auf die Ringe auftreffende Lichtanteil geht üblicherweise durch Reflektion verloren, es sei, die Ringe bestehen aus einem Material, welches eine Phasenverschiebung das auftreffenden Lichtes um die halbe Lichtwellenlänge bewirkt ( o.g. Fundstelle, Seite 376, "phase reversal zone plate").In diesem Fall wird auch der auf die Ringe auftreffende Teil des Lichtes durch die Öffnung geleitet. Der Einsatz Fresnelscher Beugungsgitter ist nach dem Stand der Technik für bestimmte Anwendungszwecke bekannt ( z.B. Telekommunikation, Laser-Fokussierung). Diese Beugungsgitter können auch eine von der Kreisform abweichende z.B. elliptische Gestaltung erfahren, um Korrekturen von optischen Verzerrungen der verwendeten Linsensysteme zu bewirken ( Ausgleich der Lichteinfallswinkel bei nicht kollimierten Licht).

Die Erfindung ist durch Verwendung monochromatischen Lichtes im ultravioletten Bereich oder durch Verwendung nicht monochromatischen Lichtes mit einem Hauptanteil im ultravioletten Bereich realisierbar. Im Handel sind (Xenon)-Blitzlicht-Einheiten mit einem UV Licht- Hauptanteil (z.B. "PX-440" der Firma Perkin Elmer / U.S.A.),
UV Licht verträgliche Kippspiegel-Elemente-Halbleiter-Chips (z.B. "UV DLP" (digital light processing) der Firma Texas Instruments/ U.S.A.) und
UV Licht sensitive Aufzeichnungsträger (z.B."LDI 330 Resist" der Firma Dupont / U.S.A.) verfügbar.

Nach der Erfindung können fotographische Vorlagen für gedruckte Leiterplatten hergestellt werden. Vorzugsweise ermöglicht die Erfindung auch eine Direktbelichtung von mit einer fotoempfindlichen Schicht versehenen Leiterplattenmaterial, welches aus einer elekrisch leitfähigen Metallschicht und einer nichtleitenden Trägerschicht besteht.
Bei einer solchen Direktbelichtung entfällt die sonst erforderliche fotografische Vorlage, da die Leiterplatte direkt (ohne Zwischenschaltung einer fotographischen Vorlage) belichtet wird.

Die Erfindung kann auch der Erstellung von Druckformen für den Hoch-, Tief-, Flach-, Durch- und Siebdruck dienen.

In den Fällen, in denen ein aufzuzeichnendes Bild die Breite b der Belichtungsstation übersteigt, kann erfindungsgemäß die Aufzeichnung des Bildes in mehreren Durchläufen des Aufzeichnungsträgers durch die Belichtungsstation erfolgen.
In jedem Durchlauf wird ein "Bild- Streifen" des gedachten Gesamtbildes erzeugt wird. Für einen solchen Fall muß die Verschiebeeinrichtung nicht nur in Richtung v verschieblich sein, sondern auch noch senkrecht dazu.

Die Erfindung kann somit in den verschiedensten Anwendungsgebieten benutzt werden, welche die Aufzeichnung eines Rasterbildes auf einen lichtempfindlichen Aufzeichnungsträger voraussetzen.

Es sind auch Anwendungen denkbar, in denen der lichtempfindliche Aufzeichnungstzräger nicht aus einem chemisch zu entwickelndem Material besteht, sondern aus einem Material, welches bei Belichtung elektrische Aufladungen erfährt, die wiederum ladungssensitiven abdruckfähigen Toner anziehen bzw. abstoßen.

Die Verschiebe-Einrichtung kann eine Schrittmotor-gesteuerte Einrichtung, eine Linearmotor-gesteuerte Einrichtung, eine piezokristall-gesteuerte Einrichtung sein, ebenso auch eine Kombination aus den vorgenannten Einrichtungen.

## Patentansprüche

1. Verfahren zur Aufzeichnung eines computergespeicherten Rasterbildes auf einen ebenen lichtempfindlichen Aufzeichnungsträger,
bei dem das aus Rasterpunkten bestehende Rasterbild mittels Blitzlicht und einer mit Steuermustern per Computerprogrammm beaufschlagbaren Licht-Steuer-Einheit erzeugt wird,
bestehend aus matrixartig angeordneten Licht-SteuerElementen,
welche Rasterpunktpositionen des Rasterbildes zugeordnet werden,
wobei von jedem Licht-Steuer-Element ein steuerbarer Lichtstrahl zur Aufzeichnung eines Bildpunktes auf den Aufzeichnungsträger leitbar ist an eine ihm zugeordnete Raterpunktposition einer Aufzeichnungsfläche in einer Belichtungsstation,
und wobei
der Aufzeichnungsträger gegenüber der Licht-Steuer-Einheit (oder umgekehrt) verschoben wird bei gleichbleibendem Abstand der Ebene , in welcher der Aufzeichnungsträger liegt, von der Ebene, in welcher die Licht-Steuer-Einheit liegt,
**dadurch gekennzeichnet,**
**daß** in an sich bekannter Weise der Aufzeichnungsträger (1) gegenüber der Licht-Steuer-Einheit (4) (oder umgekehrt) eine kontinuierliche oder schrittweise geradlinige Bewegung in Richtung v ausführt,
**daß** der Aufzeichnungsträger (1) -in Bewegungsrichtung v gesehen- in gedachte aufeinanderfolgende und einander angrenzende gleichgroße Bildfelder I1, I2, I3, ...aufgeteilt ist,
**daß** für jeden Zeitpunkt (t1, t2, t3,...) einer Blitzbelichtung die Licht-Steuer-Einheit (4) mit einem Steuermuster geladen wird für die Aufzeichnung eines diesem Steuermuster entsprechenden Teilbildes (R1, R2, R3,..) auf dem Aufzeichnungsträger (1) in einer Belichtungsstation (6), daß die Aufzeichnung aller Bildpunkte eines Teilbildes (R1, R2, R3, R4, ...) gleichzeitig erfolgt,
**daß** die Belichtungsstation (6) immer die gleiche Position bezüglich der Licht-Steuer-Einheit (4) einnimmt,
**daß** die Blitzbelichtungen zu Zeitpunkten (t1, t2, t3,..) erfolgen, zu denen sich der Aufzeichnungsträger (1) gegenüber der Licht-Steuer-Einheit (4) (oder umgekehrt) um eine äquidistante Verschiebestrecke (d) verschoben hat,
wobei die Verschiebestrecke (d) kleiner ist als die Abmessung (h) eines Bildfeldes (I1, I2, I3,...) bzw. eines Teilbildes in Bewegungsrichtung v.

2. Verfahren nach Anspruch 1,
**dadurch gekennzeichnet,**
**daß** die Licht-Steuer-Einheit (4) mit von einer Blitzlicht-Einheit (5) ausgehendem Blitzlicht beaufschlagt wird.

3. Verfahren nach Anspruch 2,
**dadurch gekennzeichnet,**
**daß** die Umsetzung des Computer-Rasterbildes in steuerbare Lichtstrahlen zur Bildaufzeichnung über ein blitzlichtbeaufschlagtes Kippspiegel-Elemente-Halbleiter-Chip erfolgt.

4. Verfahren nach Anspruch 2,
**dadurch gekennzeichnet**,
die Umsetzung des Computer-Rasterbildes in steuerbare Lichtstrahlen zur Bildaufzeichnung über eine Matrix
steuerbarer Licht-Ventil-Elemente erfolgt.

5. Verfahren nach Anspruch 1,
**dadurch gekennzeichnet,**
**daß** die Umsetzung des Computer-Rasterbildes in steuerbare Lichtstrahlen zur Bildaufzeichnung über eine Matrix Blitzlicht emittierender Elemente erfolgt.

6. Verfahren nach einem der Ansprüche 1 bis 5,
**dadurch gekennzeichnet, daß**
die Größe des in der Belichtungsstation (6) erzeugten Teilbildes (R1, R2, R3,..) durch ein zwischen der Licht-Steuer-Einheit (4) und dem Aufzeichnungsträger (1) angeordnetes maßstabsbestimmendes Objektiv (7) bestimmt wird.

7. Verfahren nach einem der Ansprüche 1 bis 6,
**dadurch gekennzeichnet,**
**daß** das aufzuzeichnende computergespeicherte Raster-Bild als Gesamtbild (T)
durch aufeinanderfolgende teilweise Überlagerung von Teilbildern (R1, R2, R3, R4, ...) erzeugt wird,
wobei die Teilbilder nacheinander in der Belichtungsstation (6) auf dem Aufzeichnungsträger (1) zu Zeitpunkten (t1, t2, t3, ...) einer Blitzlicht-Belichtung aufgezeichnet werden, zu denen sich der Aufzeichnungsträger (1) gegenüber der Licht-Steuer-Einheit (4) jeweils um eine äquidistante Verschiebestrecke (d) verschoben hat,
wobei die Licht-Steuer-Einheit (4) für jeden Belichtungszeitpunkt (t1, t2, t3, t4,...) mit einem Steuermuster für die Aufzeichnung eines Teilbildes (R1, R2, R3, R4, ...) beaufschlagt wird,
welches mit einem Abschnitt des gedachten Gesamtbildes (T) auf dem Aufzeichnungsträger (1) deckungsgleich ist,

8. Verfahren nach einem der Ansprüche 1 bis 7,
**dadurch gekennzeichnet, daß**
der Aufzeichnungsträger (1) gegenüber der Licht-Steuer-Einheit (4) mit kontinulierlicher Bewegung verschoben wird.

9. Verfahren nach einem der Ansprüche 1 bis 8,
**dadurch gekennzeichnet,**
**daß** die Bildaufzeichnung mit Blitzen gleicher oder nahezu gleicher Blitzenergie erfolgt zur Erzeugung einer durchgehenden Aufzeichnungstiefe im Aufzeichnungsträger (1).

10. Verfahren nach einem der Ansprüche 1 bis 8,
**dadurch gekennzeichnet,**
**daß** die Bildaufzeichnung in mehreren Durchläufen des Aufzeichnungsträgers (1) durch die Belichtungsstation (6) erfolgt,
wobei in jedem Durchlauf die Bildaufzeichnung mit Blitzen gleicher oder nahezu gleicher Blitzenergie erfolgt
jedoch die Blitzenergie pro Durchlauf unterschiedlich ist zur Erzeugung von Aufzeichnungen mit unterschiedlicher Aufzeichnungstiefe im Aufzeichnungsträger (1).

11. Verfahren nach einem der Ansprüche 1 bis 10, **gekennzeichnet durch**
Verwendung monochromatischen Lichtes im ultravioletten Bereich oder
**durch** Verwendung nicht monochromatischen Lichtes mit einem Hauptanteil im ultravioletten Bereich.

12. Verfahren nach einem der Ansprüche 1 bis 9 oder 11,
**gekennzeichnet durch**
seine Anwendung zur Erstellung fotographischer Vorlagen für gedruckte Leiterplatten.

13. Verfahren nach einem der Ansprüche 1 bis 9 oder 11,
**gekennzeichnet durch**
seine Anwendung zur Direktbelichtung von mit einer fotoempfindlichen Schicht versehenem Leiterplattenmaterial, welches aus einer elekrisch leitfähigen Metallschicht und einer nichtleitenden Trägerschicht besteht.

14. Verfahren nach einem der Ansprüche 1 bis 9 oder 11,
**gekennzeichnet durch**
seine Anwendung zur Erstellung von Druckformen für den Hoch-, Tief-, Flach-, Durch- und Siebdruck.

15. Verfahren nach Anspruch 10,
**gekennzeichnet durch**
seine Anwendung zur Erstellung von dreidimensionalen Strukturen in der lichtempfindlichen Schicht für optische Elemente zur optischen oder Phasen-Fokussierung.

16. Verfahren nach einem der Ansprüche 1 bis 15,
**dadurch gekennzeichnet,**
**daß** die Aufzeichnung eines die Breite (b) der Belichtungsstation (2) übersteigenden Bildes in mehreren Durchläufen des Aufzeichnungsträgers (1) durch die Belichtungsstation (6) erfolgt, wobei in jedem Durchlauf ein Bildstreifen (B1', B2', B3',..) des gedachten Gesamtbildes erzeugt wird.

17. Verfahren nach einem der Ansprüche 1 bis 16,
**dadurch gekennzeichnet, daß**
zur Verringerung meßtechnisch erfaßter Abweichungen von einer homogenen Aufzeichnungsstärke z für die einzelnen Bildpunkte an den Rasterpositionen (p) des Aufzeichnungsträgers (1) - quer zur Bewegungsrichtung v des Aufzeichnungsträgers gesehen
a) die Licht-Steuer-Elemente (c) computerprogrammgesteuert unter Berücksichtigung dieser Abweichungen derart gesteuert werden, daß bei der Erzeugung von Teilbildern Licht-Steuer-Elemente für Bildpunkte ursprünglich zu hoher Aufzeichnungsstärke deaktiviert werden;
b) zwischen der Licht-Steuer-Einheit (4) und dem Aufzeichnungsträger (1) ein diese Abweichungen ausgleichendes Filter angeordnet wird;
c) die Aufzeichnung des Bildes in mehreren Durchläufen des Aufzeichnungsträgers (1) durch die Belichtungsstation (6) erfolgt, wobei in jedem Durchlauf ein Bildstreifen (B1*, B2*) erzeugt wird und wobei benachbarte Bildstreifen randwärts einander teilweise (w*) überlappen.

18. Anordnung zur Aufzeichnung
eines computergespeicherten Rasterbildes auf einen ebenen lichtempfindlichen Aufzeichnungsträger,
bei dem das aus Rasterpunkten bestehende Rasterbild mittels Blitzlicht und einer mit Steuermustern per Computerprogrammm beaufschlagbaren Licht-Steuer-Einheit erzeugbar ist, bestehend aus matrixartig angeordneten steuerbaren Licht-Steuer-Elementen,
mit einer Verschiebe-Einrichtung und einem darauf angeordneten Aufzeichnungsträger,
mit einem Computer zur Speicherung des auf dem Aufzeichnungsträger aufzeichenbaren Bildes und zur verschiebungsbezogenen Steuerung der Licht-Steuer-Einheit und der Belichtungszeitpunkte,
**dadurch gekennzeichnet, daß**
die Verschiebe-Einrichtung (2) mindestens in einer Richtung (v) gegenüber der Licht-Steuer-Einheit (4) (oder umgekehrt) verschieblich ist,
daß für äquidistante Verschiebepositionen (d) in der Licht-Steuer-Einheit (4) für jede äquidistante Verschiebeposition ein Steuermuster zur Aufzeichnung eines Teilbildes (R1, R2, R3,..) einstellbar ist,
welches gleichzeitig bei Blitz-Belichtung auf dem Aufzeichnungsträger (1) in einer Belichtungsstation (6) aufzeichenbar ist,
daß die Belichtungsstation (2) immer in gleicher Position bezüglich der Licht-Steuer-Einheit (4) angeordnet ist,
daß das in einer äquidistanten Verschiebeposition aufzeichenbare Teilbild (R1) mit dem in der nachfolgenden äquidistanten Verschiebeposition aufzeichenbaren Teilbild (R2) teilweise derart überlagerbar ist,
daß jedes Teilbild mit einem Abschnitt des Rasterbildes (T) auf
dem Aufzeichnungsträger (1) deckungsgleich ist.

19. Anordnung nach Anspruch 18,
**dadurch gekennzeichnet,**
**daß** zwischen der Licht-Steuereinheit (4) und dem Aufzeichnungsträger (1) ein den Abbildungsmaßstab des Teilbildes bestimmendes Objektiv (7) angeordnet ist.

20. Anordnung nach Anspruch 18,
**dadurch gekennzeichnet,**
**daß** die Verschiebe-Einrichtung eine Schrittmotor-gesteuerte Einrichtung, eine Linearmotor-gesteuerte Einrichtung, eine piezokristall-gesteuerte Einrichtung oder eine Kombination vorgenannter Einrichtungen ist.
